(19) Europäisches Patentamt

European Patent Office

Office européen des brevets

(11) **EP 1 632 591 A1**

(12) **EUROPEAN PATENT APPLICATION**
published in accordance with Art. 158(3) EPC

(43) Date of publication:
08.03.2006 Bulletin 2006/10

(51) Int Cl.:
**C30B 29/06** (1980.01)

(21) Application number: **04725526.0**

(22) Date of filing: **02.04.2004**

(86) International application number:
**PCT/JP2004/004872**

(87) International publication number:
**WO 2004/101867 (25.11.2004 Gazette 2004/48)**

(84) Designated Contracting States:
**DE FR GB**

(30) Priority: **15.05.2003 JP 2003137727**

(71) Applicant: **Shin-Etsu Handotai Co., Ltd**
**Tokyo 100-0005 (JP)**

(72) Inventors:
• **YOSHIDA, Tomosuke,**
**c/o Shin-Etsu Handotai Co., Ltd**
**Annaka-shi, Gunma 3790196 (JP)**

• **TSUNODA, Hitoshi,**
**c/o Shin-Etsu Handotai Co., Ltd.**
**Annaka-shi, Gunma 3790196 (JP)**
• **KATO, Masahiro,**
**c/o Shin-Etsu Handotai Co., Ltd.**
**Annaka-shi, Gunma 3790196 (JP)**

(74) Representative: **Jones, Helen M.M.**
**Gill Jennings & Every LLP**
**Broadgate House**
**7 Eldon Street**
**London EC2M 7LH (GB)**

(54) **SILICON EPITAXIAL WAFER, AND SILICON EPITAXIAL WAFER PRODUCING METHOD**

(57) A silicon epitaxial wafer (W) comprising: a silicon single crystal substrate (1) having a COP (100) on a main surface (11), and a silicon epitaxial layer (2) grown by vapor phase epitaxy on the main surface (11) of the silicon single crystal substrate (1), wherein the main surface (11) is inclined from a (100) plane in a [011] direction or a [0-1-1] direction by an angle $\theta$ with respect to a [100] axis as well as inclined from a (100) plane in a [01-1] direction or a [0-11] direction by an angle $\phi$ with respect to a [100] axis, and at least one of the angle $\theta$ and the angle $\phi$ is from 0° to 15'.

## FIG.4

OFF ANGLE IN [0$\bar{1}$1] DIRECTION

OFF ANGLE IN [0$\bar{1}\bar{1}$] DIRECTION

OFF ANGLE IN [011] DIRECTION

OFF ANGLE IN [01$\bar{1}$] DIRECTION

**Description**

Technical Field

The present invention relates to a silicon epitaxial wafer in which a silicon epitaxial layer formed on a main surface of a silicon single crystal substrate, and a manufacturing method thereof.

Background Art

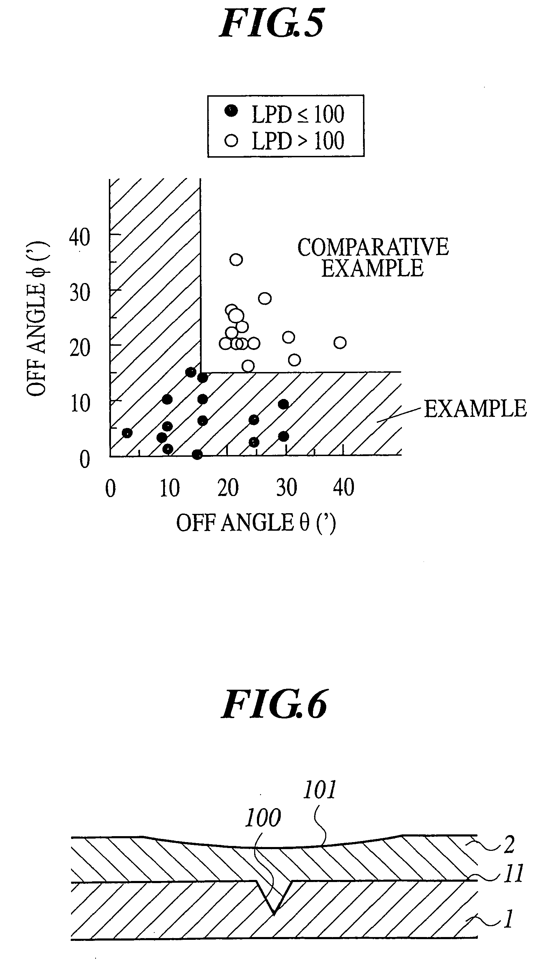

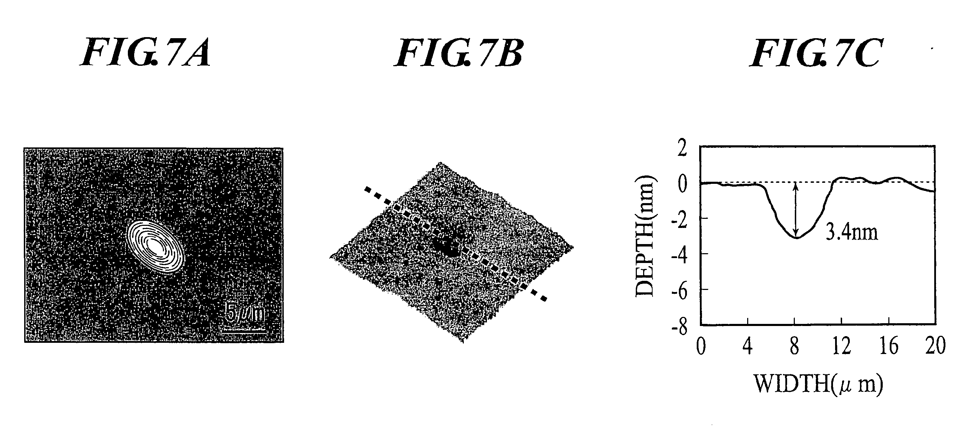

Conventionally, in order to manufacture a silicon epitaxial wafer, a silicon single crystal ingot which is pulled up, for example, by a CZ (Czochralski) method, is subjected to chamfering, slicing, lapping, etching and mirror-polishing to prepare a silicon single crystal substrate. Further, silicon materials are fed to a main surface of the silicon single crystal substrate under high temperature conditions to grow a silicon epitaxial layer by vapor phase epitaxy on the main surface.
In the above-described manufacturing method of a silicon epitaxial wafer, when pulling up the silicon single crystal ingot by the CZ method, a minute void may occur in the silicon single crystal. Further, when the void occurs on the main surface of the silicon single crystal substrate, a minute pit which is a so-called COP (Crystal Originated Particle) 100 having a diameter of about 0.2 μm is formed on the main surface 11, as shown in FIG. 6. When growing a silicon epitaxial layer 2 by vapor phase epitaxy on the main surface 11 of the silicon single crystal substrate 1 where the COP 100 is thus formed, a pit 101 having a diameter of several μm and a depth of several nm, which is caused by the COP 100, may be formed on a surface of the layer 2 depending on vapor-phase epitaxy conditions, as shown in FIGS. 7A to 7C (see, for example, Japanese Patent Application Publication Unexamined No. 2001-068420). The pit 101 is detected as an LPD (Light Point Defect) by a laser silicon surface inspection apparatus. Hereinafter, the pit 101 is described as an LPD 101. A width and depth of the LPD 101 as shown in FIG. 7C are values measured along a broken line of FIG. 7B.
On the other hand, when growing the silicon epitaxial layer by vapor phase epitaxy in a state where moisture or heavy metals adhere to the main surface of the silicon single crystal substrate, a pit which is a so-called teardrop having a diameter of about 10 μm may occur on the main surface of the silicon epitaxial wafer. For a technology for suppressing occurrence of the teardrop, there is disclosed a technology for manufacturing a silicon epitaxial wafer using a silicon single crystal substrate of which the main surface is off-angled from a (100) plane in a predetermined direction by a predetermined angle (see, for example, Japanese Patent Application Publication Unexamined Tokukaisho-62-226891). However, Japanese Patent Application Publication Unexamined Tokukaisho-62-226891 discloses no technology for suppressing occurrence of the LPD caused by the COP although disclosing the technology for suppressing occurrence of the teardrop.
As described above, when the pit caused by the COP occurs on the surface of the silicon epitaxial layer, a laser silicon surface inspection apparatus counts the pit as the LPD in the same manner as in crystal defects or particles.
It is an object of the present invention to provide a silicon epitaxial wafer which is suppressed in occurrence of the LPD caused by the COP and a manufacturing method of the silicon epitaxial wafer capable of suppressing occurrence of the LPD caused by the COP.

Disclosure of Invention

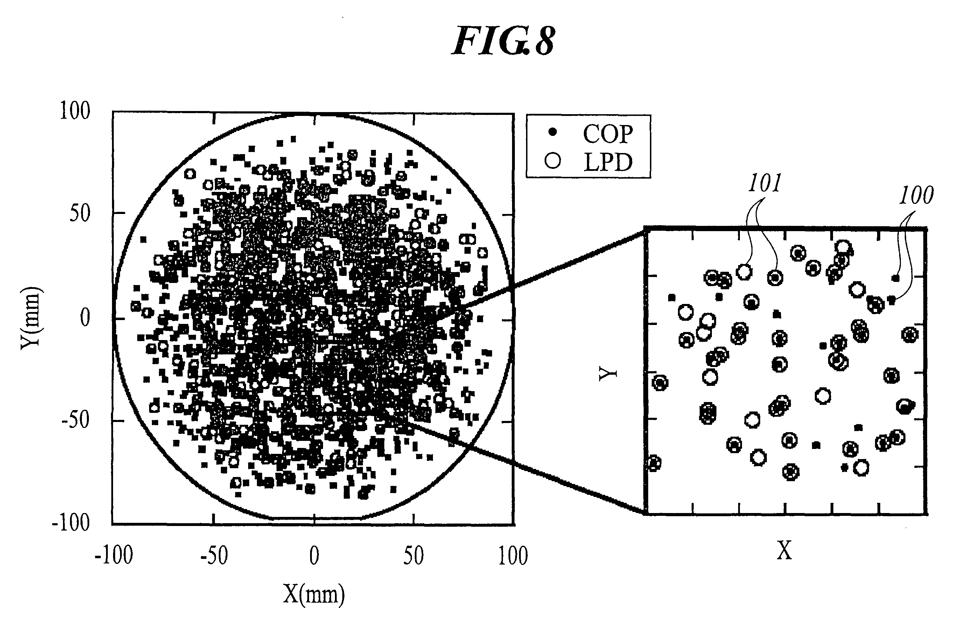

FIG. 8 shows an occurrence position of an LPD 101 in the case of growing a silicon epitaxial layer 2 by vapor phase epitaxy on a main surface 11 of a silicon single crystal substrate 1 of which the main surface is inclined from a (100) plane in a [011] direction and a [0-11] direction by 23' with respect to a [100] axis and which has a COP 100 on the main surface thereof. From this drawing, it is found that the occurrence position of the LPD 101 shows a high correlation with a position of the COP 100. Further, it is found that when the COP 100 is transferred to a surface of the silicon epitaxial layer 2, the LPD 101 is formed on the surface thereof.
However, when the main surface of the silicon single crystal substrate is inclined from the (100) plane in the [011] direction and the [0-11] direction by an angle equal to or less than 15' with respect to the [100] axis, the LPD caused by the COP is hardly formed on the surface of the silicon epitaxial layer, despite the substrate 1 having the COP on the main surface thereof.
As a result of extensive investigations, the present inventors have found that when adjusting the main surface of the silicon single crystal substrate to substantially have a constant inclination from the (100) plane only in a particular direction, the transfer of the COP to the surface of the silicon epitaxial layer can be prevented, and as a result, occurrence of the LPD can be suppressed.
That is, according to a first aspect of the present invention, the silicon epitaxial wafer of the present invention comprises;
a silicon single crystal substrate having a COP on a main surface, and
a silicon epitaxial layer grown by vapor phase epitaxy on the main surface of the silicon single crystal substrate, wherein

the main surface is inclined from a (100) plane in a [011] direction or a [0-1-1] direction by an angle $\theta$ with respect to a [100] axis as well as inclined from a (100) plane in a [01-1] direction or a [0-11] direction by an angle $\phi$ with respect to a [100] axis, and

at least one of the angle $\theta$ and the angle $\phi$ is from 0° to 15'.

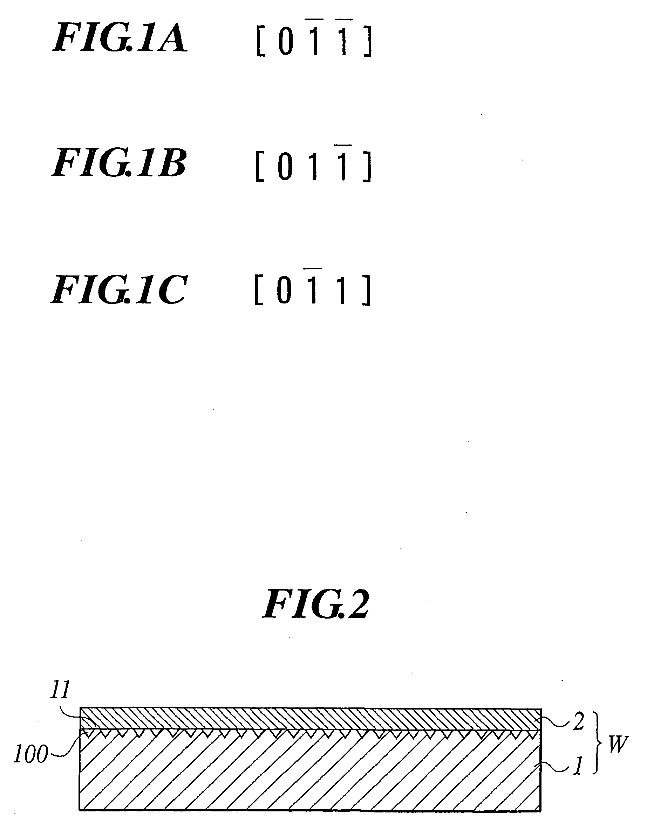

Herein, the [0-1-1] direction, [01-1] direction and [0-11] direction mean directions shown in FIGS. 1A to 1C, respectively.

According to the present invention, the main surface of the silicon single crystal substrate is off-angled from the (100) plane in the [011] direction or the [0-1-1] direction by an angle $\theta$ with respect to the [100] axis as well as off-angled from the (100) plane in the [01-1] direction or the [0-11] direction by an angle $\phi$ with respect to the [100] axis, and at least one of the angle $\theta$ and the angle $\phi$ is from 0° to 15'. As a result, when growing the silicon epitaxial layer by vapor phase epitaxy on the main surface of the silicon single crystal substrate, the COP on the main surface can be prevented from being transferred to the surface of the silicon epitaxial layer. Accordingly, the occurrence of the LPD caused by the COP can be suppressed.

Herein, the reason why at least one of the angle $\theta$ and the angle $\phi$ is from 0° to 15' is as follows. That is, when the silicon single crystal substrate has the COP on the main surface and both of the angle $\theta$ and the angle $\phi$ with respect to the (100) plane are larger than 15', the COP is easy to be transferred to the surface of the silicon epitaxial layer, and as a result, occurrence of the LPD caused by the COP becomes marked.

Further, the silicon epitaxial wafer of the present invention is preferably such that the angle $\theta$ and the angle $\phi$ satisfy the following inequalities:

$$0° \le \theta \le 5°, \ 0° \le \phi \le 15'$$

or

$$0° \le \phi \le 5°, \ 0° \le \theta \le 15',$$

and more preferably such that the angle $\theta$ and the angle $\phi$ satisfy the following inequalities:

$$3' \le \theta \le 30', \ 0° \le \phi \le 15'$$

or

$$3' \le \phi \le 30', \ 0° \le \theta \le 15'.$$

In this case, the occurrence of the LPD caused by the COP can be surely suppressed.

According to a second aspect of the present invention, a silicon epitaxial wafer manufacturing method of the present invention comprises a step of:

growing a silicon epitaxial layer by vapor phase epitaxy on a main surface of a silicon single crystal substrate, wherein when the silicon single crystal substrate having a COP on the main surface is used, the main surface is inclined from a (100) plane in a [011] direction or a [0-1-1] direction by an angle $\theta$ with respect to a [100] axis as well as inclined from a (100) plane in a [01-1] direction or a [0-11] direction by an angle $\phi$ with respect to a [100] axis, and at least one of the angle $\theta$ and the angle $\phi$ is from 0° to 15' .

According to the present invention, the silicon single crystal substrate of which the main surface is inclined from the (100) plane in the [011] direction or [0-1-1] direction by an angle $\theta$ with respect to the [100] axis as well as inclined from the (100) plane in the [01-1] direction or [0-11] direction by an angle $\phi$ with respect to the [100] axis and in which at least one of the off angle $\theta$ and the off angle $\phi$ is from 0° to 15', is used. As a result, when growing the silicon epitaxial layer by vapor phase epitaxy on the main surface of the silicon single crystal substrate where the COP is formed, the COP on the main surface can be prevented from being transferred to the surface of the silicon epitaxial layer. Accordingly, the occurrence of the LPD caused by the COP can be suppressed.

Further, in the silicon epitaxial wafer manufacturing method of the present invention, a silicon single crystal substrate used in vapor-phase epitaxy is preferably such that the angle θ and the angle φ satisfy the following inequalities:

$$0° \leq \theta \leq 5°, \quad 0° \leq \phi \leq 15'$$

or

$$0° \leq \phi \leq 5°, \quad 0° \leq \theta \leq 15',$$

and more preferably such that the angle θ and the angle φ satisfy the following inequalities:

$$3' \leq \theta \leq 30', \quad 0° \leq \phi \leq 15'$$

or

$$3' \leq \phi \leq 30', \quad 0° \leq \theta \leq 15'.$$

In this case, the occurrence of the LPD caused by the COP can be surely suppressed.

Brief Description of Drawings

FIG. 1A shows a [0-1-1] direction.
FIG. 1B shows a [01-1] direction.
FIG. 1C shows a [0-11] direction.
FIG. 2 is a longitudinal sectional view showing a silicon epitaxial wafer according to the present invention.
FIG. 3 illustrates an inclination (an off angle) of a main surface of a silicon single crystal substrate.
FIG. 4 shows an inclination range of a main surface of a silicon single crystal substrate.
FIG. 5 shows a relationship between an off angle of a main surface of a silicon single crystal substrate and the number of LPDs detected on a main surface of one silicon epitaxial wafer.
FIG. 6 is a longitudinal sectional view showing a relationship between a COP and an LPD.
FIGS. 7A to 7C show a pit detected as an LPD. FIG. 7A is a plan view of the LPD, FIG. 7B is a perspective view of the LPD and FIG. 7C is a longitudinal sectional view of the LPD.
FIG. 8 shows a correlation between a COP position and an LPD position.

Best Mode for Carrying Out the Invention

Embodiments of the silicon epitaxial wafer according to the present invention will be described below with reference to the accompanying drawings.

FIG. 2 is a longitudinal sectional view showing a silicon epitaxial wafer W.

As shown in the drawing, the silicon epitaxial wafer W has a silicon single crystal substrate 1 in which a silicon epitaxial layer 2 is grown by vapor phase epitaxy on a main surface 11.

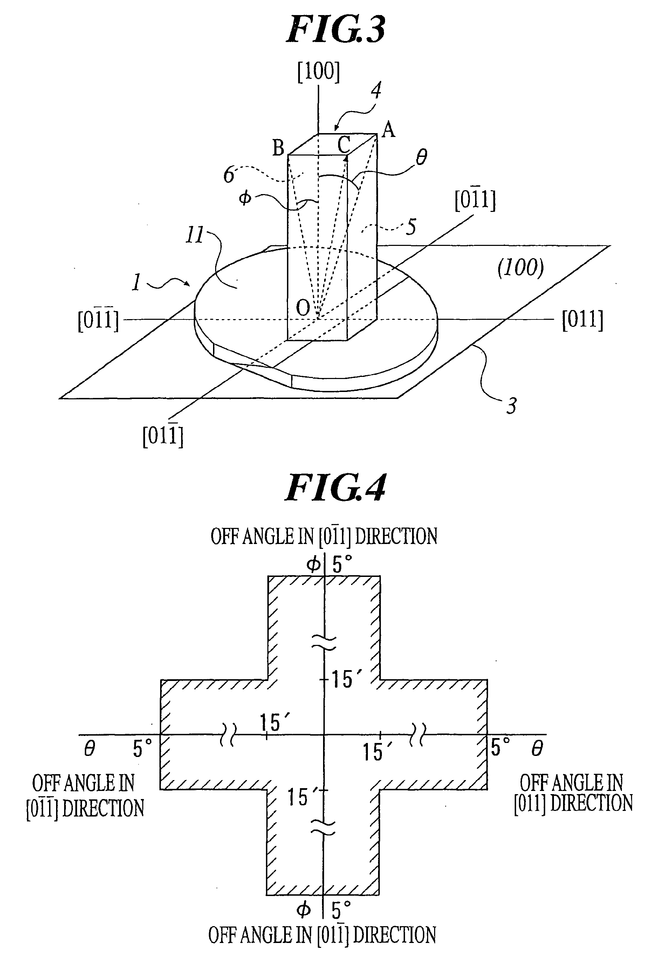

On the main surface 11 of the silicon single crystal substrate 1, a COP 100 is formed. Further, the main surface 11 of the silicon single crystal substrate 1 is adjusted to substantially have a constant inclination (an off angle) from a (100) plane only in a particular direction. Herein, the off angle of the main surface 11 of the silicon single crystal substrate 1 is described with reference to FIG. 3.

Now, one point within the (100) plane 3 is designated as the origin O. Further, crystal axes [011], [0-1-1], [01-1] and [0-11] that pass through the origin O are provided within the (100) plane 3. Further, a rectangular parallelepiped 4 is arranged on the (100) plane 3. More specifically, one vertex of the rectangular parallelepiped 4 is placed at the origin. Then, three sides concentrated in this vertex are allowed to coincide with the [011], [01-1] and [100] axes, respectively, to thereby arrange the rectangular parallelepiped 4.

At this time, when assuming that inclination angles (off angles) formed between a diagonal OA on a side surface 5 of the rectangular parallelepiped 4 and the [100] axis as well as between a diagonal OB on a side surface 6 of the rectangular parallelepiped 4 and the [100] axis are an angle θ and an angle φ, respectively, the silicon single crystal substrate 1 having a diagonal OC of the rectangular parallelepiped 4 as a normal line is a substrate of which the main surface 11 is inclined from the (100) plane in the [011] direction by the angle θ with respect to the [100] axis as well as inclined from the (100) plane in the [01-1] direction by the angle φ with respect to the [100] axis. As shown in FIG. 4, at least one of these angles θ and φ is from 0° to 15'. Therefore, as shown in FIG. 2, the LPD 101 caused by transfer of the COP 100 is prevented from occurring on the surface of the silicon epitaxial layer 2.

Next, the manufacturing method of the silicon epitaxial wafer W according to the present invention is described.

First, a silicon single crystal ingot (not shown) is pulled up using the CZ method. At this time, voids occur inside the silicon single crystal ingot.

Next, the silicon single crystal ingot is subjected to block cutting and chamfering.

Subsequently, the silicon single crystal ingot is sliced. More specifically, the silicon single crystal ingot is sliced such that the main surface 11 of the silicon single crystal substrate 1 to be manufactured is inclined from the (100) plane in the [011] direction by the angle θ with respect to the [100] axis as well as inclined from the (100) plane in the [01-1] direction by the angle φ with respect to the [100] axis, and such that at least one of these angles θ and φ is from 0° to 15'. Further, the ingot is subjected to surface treatment such as lapping, etching, mirror-polishing and washing to prepare the silicon single crystal substrate 1. At this time, voids occur on the main surface 11 of the silicon single crystal substrate 1 and as a result, the COP 100 is formed on the main surface 11.

Then, the silicon epitaxial layer 2 is grown by vapor phase epitaxy on the main surface 11 of the silicon single crystal substrate 1. At this time, the COP 100 on the main surface 11 of the silicon single crystal substrate 1 is prevented from being transferred to the surface of the silicon epitaxial layer 2, so that occurrence of the LPD 101 caused by the COP can be suppressed.

In the above-described embodiment, it is described that the main surface 11 of the silicon single crystal substrate 1 is inclined from the (100) plane in the [011] direction and the [01-1] direction with respect to the [100] axis. The main surface 11 may be inclined in the [011] direction and the [0-11] direction, or may be inclined in the [0-1-1] direction and the [0-11] direction, or may be inclined in the [0-1-1] direction and the [01-1] direction.

Examples

The present invention will be described in detail below with reference to Examples and Comparative Examples.

<Example 1>

In Example 1, A silicon epitaxial layer was grown by vapor phase epitaxy on a main surface of a silicon single crystal substrate having a COP on the main surface thereof and of which the main surface has the angle θ and the angle φ satisfying the following inequalities:

$$3' \leq \theta \leq 30', \ 0° \leq \phi \leq 15'$$

or

$$3' \leq \phi \leq 30', \ 0° \leq \theta \leq 15'.$$

A diameter of the silicon single crystal substrate used is 200 mm.

<Comparative Example>

In Comparative Example, A silicon epitaxial layer was grown by vapor phase epitaxy on the main surface of the substrate having a COP on a main surface thereof and of which the main surface has the angle θ and the angle φ satisfying the following inequalities:

$$15' < \theta \leq 40' \text{ or } 15' < \phi \leq 40'.$$

A diameter of the silicon single crystal substrate used is 200 mm.

FIG. 5 shows the number of LPDs detected on the main surfaces of the silicon epitaxial wafers, that is, on the surfaces of the silicon epitaxial layers, which are manufactured by the above Example 1 and Comparative Example.

As shown in the drawing, in Example 1, the number of the LPDs detected on the main surface of one silicon epitaxial wafer was equal to or less than 100 pieces in all wafers. The number of the LPDs in Example was smaller than that in Comparative Example where the number of the LPDs exceeds 100 pieces in all wafers. In other words, the occurrence of the LPD caused by the COP on the main surface of the silicon single crystal substrate could be suppressed in Example.

<Example 2>

Three silicon single crystal substrates (No. 1 to No. 3) of which the main surface is inclined from the (100) plane in the [011] direction by an angle θ with respect to the [100] axis as well as inclined from the (100) plane in the [0-11] direction by an angle φ with respect to the [100] axis, were prepared. Table 1 shows the angle θ and the angle φ in each of the three silicon single crystal substrates.

### Table 1

| NO. OF SILICON SINGLE CRYSTAL SUBSTRATE / OFF ANGLE | θ | φ |
|---|---|---|
| No.1 | 4.8′ | 3.97° |
| No.2 | 10.2′ | 4.22° |
| No.3 | 9.0′ | 4.02° |

The COPs were observed in the silicon single crystal substrates. As a result, it was found that more than 1000 COPs per one substrate occur in any of the silicon single crystal substrates.

On the main surfaces of these silicon single crystal substrates, the silicon epitaxial layers were grown by vapor phase epitaxy to manufacture the silicon epitaxial wafers. It was found that no LPD caused by the COP occur in any of the main surfaces of the silicon epitaxial wafers.

Herein, the angle θ and the angle φ are interchangeable. From the results of Examples 1 and 2, it is found that when the angle θ and the angle φ are 0°≤θ≤5°, 0°≤φ≤15′ or 0°≤φ≤5°, 0°≤θ≤15′, more preferable 3′≤θ≤30′, 0°≤φ≤15′ or 3′≤φ≤30′, 0°≤θ≤15′, the occurrence of the LPD caused by the COP on the main surfaces of the silicon single crystal substrates is greatly suppressed.

Industrial Applicability

According to the present invention, when growing the silicon epitaxial layer by vapor phase epitaxy on the main surface of the silicon single crystal substrate, the COP on the main surface can be prevented from being transferred to the surface of the silicon epitaxial layer. Accordingly, the occurrence of the LPD caused by the COP can be suppressed. Therefore, the silicon epitaxial wafer and the silicon epitaxial wafer manufacturing method according to the present invention are suitable for the case of suppressing the occurrence of the LPD caused by the COP.

**Claims**

**1.** A silicon epitaxial wafer comprising:

a silicon single crystal substrate having a COP on a main surface, and
a silicon epitaxial layer grown by vapor phase epitaxy on the main surface of the silicon single crystal substrate, wherein

the main surface is inclined from a (100) plane in a [011] direction or a [0-1-1] direction by an angle θ with respect to a [100] axis as well as inclined from a (100) plane in a [01-1] direction or a [0-11] direction by an angle φ with respect to a [100] axis, and
at least one of the angle θ and the angle φ is from 0° to 15'.

2. The silicon epitaxial wafer as claimed in claim 1, wherein
   the angle θ and the angle φ satisfy following inequalities:

$$0° \leq \theta \leq 5°, \quad 0° \leq \phi \leq 15'$$

or

$$0° \leq \phi \leq 5°, \quad 0° \leq \theta \leq 15'.$$

3. The silicon epitaxial wafer as claimed in claim 2, wherein
   the angle θ and the angle φ satisfy following inequalities:

$$3' \leq \theta \leq 30', \quad 0° \leq \phi \leq 15'$$

or

$$3' \leq \phi \leq 30', \quad 0° \leq \theta \leq 15'.$$

4. A silicon epitaxial wafer manufacturing method, comprising a step of:

   growing a silicon epitaxial layer by vapor phase epitaxy on a main surface of a silicon single crystal substrate, wherein
   when the silicon single crystal substrate having a COP on the main surface is used, the main surface is inclined from a (100) plane in a [011] direction or a [0-1-1] direction by an angle θ with respect to a [100] axis as well as inclined from a (100) plane in a [01-1] direction or a [0-11] direction by an angle φ with respect to a [100] axis, and
   at least one of the angle θ and the angle φ is from 0° to 15'.

5. The silicon epitaxial wafer manufacturing method as claimed in claim 4, wherein the silicon single crystal substrate is used such that the angle θ and the angle φ satisfy the following inequalities:

$$0° \leq \theta \leq 5°, \quad 0° \leq \phi \leq 15'$$

or

$$0° \leq \phi \leq 5°, \quad 0° \leq \theta \leq 15'.$$

6. The silicon epitaxial wafer manufacturing method as claimed in claim 5, wherein the silicon single crystal substrate is used such that the angle θ and the angle φ satisfy the following inequalities:

$$3' \leq \theta \leq 30', \quad 0° \leq \phi \leq 15'$$

or

$$3' \leq \phi \leq 30', \quad 0° \leq \theta \leq 15'.$$

*FIG.1A*    [ 0 $\bar{1}$ $\bar{1}$ ]

*FIG.1B*    [ 0 1 $\bar{1}$ ]

*FIG.1C*    [ 0 $\bar{1}$ 1 ]

*FIG.2*

# *FIG.3*

# *FIG.4*

OFF ANGLE IN [0$\bar{1}$1] DIRECTION

OFF ANGLE IN
[0$\bar{1}$$\bar{1}$] DIRECTION

OFF ANGLE IN
[011] DIRECTION

OFF ANGLE IN [01$\bar{1}$] DIRECTION

# *FIG.5*

LPD ≤ 100
LPD > 100

COMPARATIVE
EXAMPLE

EXAMPLE

OFF ANGLE φ (')

OFF ANGLE θ (')

# *FIG.6*

# FIG.7A

# FIG.7B

# FIG.7C

EP 1 632 591 A1

FIG.8

**INTERNATIONAL SEARCH REPORT**

| International application No. |
|---|
| PCT/JP2004/004872 |

**A. CLASSIFICATION OF SUBJECT MATTER**
Int.Cl⁷ C30B29/06

According to International Patent Classification (IPC) or to both national classification and IPC

**B. FIELDS SEARCHED**

Minimum documentation searched (classification system followed by classification symbols)
Int.Cl⁷ C30B29/06, H01L21/205

Documentation searched other than minimum documentation to the extent that such documents are included in the fields searched

| | | | |
|---|---|---|---|
| Jitsuyo Shinan Koho | 1926-1996 | Toroku Jitsuyo Shinan Koho | 1994-2004 |
| Kokai Jitsuyo Shinan Koho | 1971-2004 | Jitsuyo Shinan Toroku Koho | 1996-2004 |

Electronic data base consulted during the international search (name of data base and, where practicable, search terms used)
WPI, Elsevier

**C. DOCUMENTS CONSIDERED TO BE RELEVANT**

| Category* | Citation of document, with indication, where appropriate, of the relevant passages | Relevant to claim No. |
|---|---|---|
| A | JP 62-226891 A (Shin-Etsu Handotai Co., Ltd.), 05 October, 1987 (05.10.87), Claims; page 2, lower left column, line 16 to page 4, upper right column, line 9 (Family: none) | 1-6 |
| A | JP 5-347256 A (Toshiba Corp.), 27 December, 1993 (27.12.93), Claims; page 2, Par. No. [0007] to page 3, Par. No. [0020] (Family: none) | 1-6 |
| A | JP 7-172990 A (NEC Corp.), 11 July, 1995 (11.07.95), Claims; page 3, Par. No. [0014] to page 14, Par. No. [0036] & US 5838058 A | 1-6 |

| ☒ Further documents are listed in the continuation of Box C. | ☐ See patent family annex. |
|---|---|

| * Special categories of cited documents: | "T" later document published after the international filing date or priority date and not in conflict with the application but cited to understand the principle or theory underlying the invention |
|---|---|
| "A" document defining the general state of the art which is not considered to be of particular relevance | |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
|---|---|
| 05 July, 2004 (05.07.04) | 20 July, 2004 (20.07.04) |

| Name and mailing address of the ISA/ | Authorized officer |
|---|---|
| Japanese Patent Office | |
| Facsimile No. | Telephone No. |

Form PCT/ISA/210 (second sheet) (January 2004)

**INTERNATIONAL SEARCH REPORT**

| | International application No. |
|---|---|
| | PCT/JP2004/004872 |

C (Continuation).   DOCUMENTS CONSIDERED TO BE RELEVANT

| Category* | Citation of document, with indication, where appropriate, of the relevant passages | Relevant to claim No. |
|---|---|---|
| P,A | JP 2004-91234 A  (Sumitomo Mitsubishi Silicon Corp.), 25 March, 2004 (25.03.04), Claims; page 3, Par. No. [0011] to page 6, Par. No. [0036] (Family: none) | 1-6 |

Form PCT/ISA/210 (continuation of second sheet) (January 2004)